# EUROPÄISCHE PATENTSCHRIFT

(11) **EP 0 187 979 B1**
(45) Veröffentlichungstag und Bekanntmachung des Hinweises auf die Patenterteilung: **07.04.1993**
(21) Anmeldenummer: 85116109.1
(22) Anmeldetag: 17.12.1985
(51) Int. Cl.: G02B 6/12, G02B 6/34

(54) **Monolithisch integrierter WDM-Demultiplexmodul und ein Verfahren zur Herstellung eines solchen Moduls**
Monolithically integrated WDM demultiplexmodule and method of manufacturing such a module
Module WDM-demultiplex intégré monolithique et procédé de sa fabrication

(30) Priorität: 07.01.1985 DE 3500306
(43) Veröffentlichungstag der Anmeldung: 23.07.1986
(60) Teilanmeldung: 91114945.8
(73) Patentinhaber: SIEMENS AKTIENGESELLSCHAFT, 80333 München (DE)
(72) Erfinder: Heinen, Jochen, Dr., D-8013 Haar (DE); Mahlein, Hans F., Dr., D-8025 Unterhaching (DE); März, Reinhard, Dr., D-8000 München 83 (DE); Plihal, Manfred, Dr., D-8000 München 82 (DE); Schlötterer, Heinrich, Dr., D-8011 Putzbrunn (DE); Winzer, Gerhard, Dr., D-8011 Putzbrunn (DE); Wolff, Ulrich, Dipl.-Phys., D-8000 München 71 (DE)

(56) Entgegenhaltungen:
- US-A- 4 115 150
- APPLIED PHYSICS LETTERS, Band. 45, Nr. 12, 1984, Seiten 1278-1280; R.C. ALFERNESS et al.: "In GaAs P/InP waveguide grating filters for Lambda-1,5 müm"
- JOURNAL OF APPLIED PHYSICS, Band. 56, Nr. 9, November 1984, Seiten 2595-2598, New York, US; K. OKAMOTO et al.: "In GaAsP double-heterostructure optical waveguides with p+x-n junction and their electroabsorption"
- APPLIED PHYSICS LETTERS, Band. 40, Nr. 2, 1982, Seiten 120-122; T. SUHARA et al.: "Monolithic integrated microgratings and photodiodes for wavelength demultiplexing"
- APPLIED PHYSICS LETTERS, Band. 31, Nr. 12, 1977, Seiten 803-806; T.R. RANGANATH et al.: "Light detection in dielectric waveguides by a photodiode through direct evanescent field coupling"
- SOVIET JOURNAL QUANTUM ELECTRONICS, Band 7, Nr. 9, 1977, Seiten 1144-1145; Y. BYKOVSKII et al: "Integrated-optic functional elements based on epitaxial GaAiAs-GaAs heterostructure"

## Beschreibung

Die vorliegende Erfindung betrifft einen monolithisch integrierten Wellenlängen-Demultiplexmodul nach dem Oberbegriff des Patentanspruchs 1 und ein Verfahren zur Herstellung eines solchen Moduls.

Ein monolithisch integrierter Wellenlängen-Demultiplexmodul und ein Verfahren zu seiner Herstellung ist aus Applied Physics Letters, Vol.40, No.2, 1982, S. 120-122 bekannt. Bei diesem bekannten Modul besteht das Substrat aus SiO₂ und der Schichtwellenleiter aus As₂S₃. Der Photodetektor besteht aus einer Schottky-Barriere-Diode.

Die Herstellung des Moduls erfolgt so, daß zunächst auf der Oberfläche des Siliziumsubstrats thermisch die Pufferschicht erzeugt und dann der Schichtwellenleiter durch Aufdampfen im Vakuum erzeugt wird. Die Fotodioden werden in Form von Schottky-Dioden ausgebildet. Das wellenlängenselektierende Gitter wird mittels Elektronenstrahl in die Oberfläche des Schichtwellenleiters eingeschrieben.

Aus Applied Physics Letters, Vol. 45, No. 12, 1984, S. 1278-1280 ist es bekannt, ein wellenlängenselektierendes Element nach dem Oberbegriff des Anspruchs 1 auf einem Schichtwellenleiter aus quaternärem Material auf einem Substrat auf InP auszubilden.

Aus Journal of Applied Physics, Vol. 55, No. 9, Nov. 1984, S. 2595-2598 ist ein Rippenwellenleiter auf einem Substrat aus n⁺-dotiertem InP bekannt, bei dem auf dem Substrat eine Schicht aus n⁺-dotiertem InGaAsP (quaternäres Material) und auf dieser Schicht eine wellenleitende und eine Rippe aufweisende Schicht aus n-dotiertem InGaAsP (quaternäres Material aufgebracht ist. Auf der Rippe ist eine Schicht aus p⁺-dotiertem InGaAsP aufgebracht. Dieser Wellenleiter ist auch als optischer Schalter oder Modulator betreibbar. Ein Hinweis auf eine Verwendung als Photodetektor oder gar als Demultiplexer fehlt in diesem Dokument. Die dort erwähnte Ge-Photodiode dient zur Messung eines Übertragungsverhaltens des Rippenwellenleiters.

Aus Sovjet Journal Quantum Electronics, Bd. 7, Nr. 9, 1977,. S. 1144-1145 ist ein Schichtwellenleiter auf einem Substrat aus GaAs bekannt, der aus einer auf einem Substrat aufgebrachten Schicht aus GaAlAs (ternäres Material), einer auf dieser Schicht aufgebrachten wellenleitenden Schicht aus GaAlAs (ternäres Material) und aus einer auf der wellenleitenden Schicht aufgebrachten Schicht aus GaAlAs besteht. Auf diesem Wellenleiter können DFB-Laser, Verstärker und Modulatoren, aber auch Dünnfilmwellenleiter-Photodioden realisiert werden. Diese Photodioden können anstelle von Schottky-Barriere-Dioden solche sein, die durch die Heterostruktur des Wellenleiters aus dem ternären Material auf der Basis von GaAs selbst gebildet sind.

Der im Anspruch 1 angegebenen Erfindung liegt die Aufgabe zugrunde, einen auf einem Substrat aus InP mit nur einem Epitaxieschritt herstellbaren Wellenlängen-Demultiplexmdoul mit einem durch Leckwellenkopplung an den Schichtwellenleiter gekoppelten Photodetektor anzugeben.

Die Herstellung in nur einem Epitaxieschritt bedeutet die Herstellung in einem einheitlichen epitaktischen Prozeß, bei dem eine oder mehrere Schichten in unmittelbarer Aufeinanderfolgende aufgewachsen werden.

Die quaternäre Schicht besteht vorzugsweise gemäß Anspruch 2 aus InGaAsP.

Vorzugsweise besteht gemäß Anspruch 3 eine ternäre Schicht aus InGaAs, insbesondere dann, wenn die quaternäre Schicht gemäß Anspruch 2 aus InGaAsP besteht.

Bei einem erfindungsgemäßen Modul nach einem der Ansprüche 3 bis 5 läßt sich die Leckwellenkopplung auf einfache Weise dadurch verbessern, daß gemäß Anspruch 4 bei dem durch Leckwellenkopplung an den Schichtwellenleiter optisch gekoppelten Fotodetektor ein quer zum Schichtwellenleiter sich erstreckendes und schräg zur Ausbreitungsrichtung des von diesem Fotodetektor empfangenen Strahlungsanteiles angeordnetes reflektierendes Element vorgesehen ist, das die am Fotodetektor vorbeigehende Strahlung in Richtung zum Fotodetektor reflektiert und/daß der Schichtwellenleiter im Bereich dieses Fotodetektors eine Verjüngung aufweist.

Der einem Fotodetektor zugeführte Strahlungsanteil kann kanalfremde und damit störende Wellenlängen enthalten. Bei einem Modul gemäß Anspruch 4 kann der Einfluß einer derartigen störenden Wellenlänge auf einfache Weise gemäß Anspruch 5 dadurch vermindert werden, daß das reflektierende Element ein Filter zur Ausfilterung der störenden Wellenlänge aufweist.

Ein erfindungsgemäßer Modul wird zweckmäßigerweise gemäß Anspruch 6 mit einer Deckschicht abgedeckt, die insbesondere bei Modulen nach den Ansprüchen 3, 4, 5, 6 oder 7 und 8 vorzugsweise gemäß Anspruch 7 aus Si₃N₄, Polyimid oder InP besteht.

Ein vorteilhaftes Verfahren zur Herstellung eines erfindungsgemäßes Moduls ist im Anspruch 8 angegeben.

Die Erfindung wird in der folgenden Beschreibung anhand der Figuren beispielhaft erläutert. Von den Figuren zeigen:
- Fig.1: eine Draufsicht auf einen schematisch dargestellten monolithisch integrierten WDM-Demultiplexmodul,
- Fig.2: einen Schnitt durch den Modul nach Fig.1 längs der Schnittlinie II-II,
- Fig.3: in der gleichen Schnittdarstellung wie in Fig.2 eine modifizierte Ausführungsform des Moduls nach Fig.1,
- Fig.4: einen Ausschnitt aus einer Schnittdarstellung gemäß Fig.2, aus der die Ausführung eines reflektierenden Elementes bei dem Fotodetektor hervorgeht,
- Fig.5 und 6: Ausschnitte gemäß Fig.4, die anstelle eines reflektierenden Elementes bei dem Fotodetektor verschiedene Ausführungen von Verjüngungen des Schichtwellenleiters im Bereich des Fotodetektors zeigen,
- Fig.7: eine Draufsicht gemäß Fig.1 auf eine modifizierte Ausführungsform eines Moduls, bei dem Maßnahmen zur Erhöhung der Nebensprechdämpfung vorgesehen sind, und
- Fig.8: einen Ausschnitt auf eine Stirnansicht eines Moduls, die eine Verdickung des Schichtwellenleiters zeigt, wobei die Stirnansicht einer Draufsicht auf die linke Seite in Richtung 12 des in Fig.1 dargestellten Moduls entspricht.

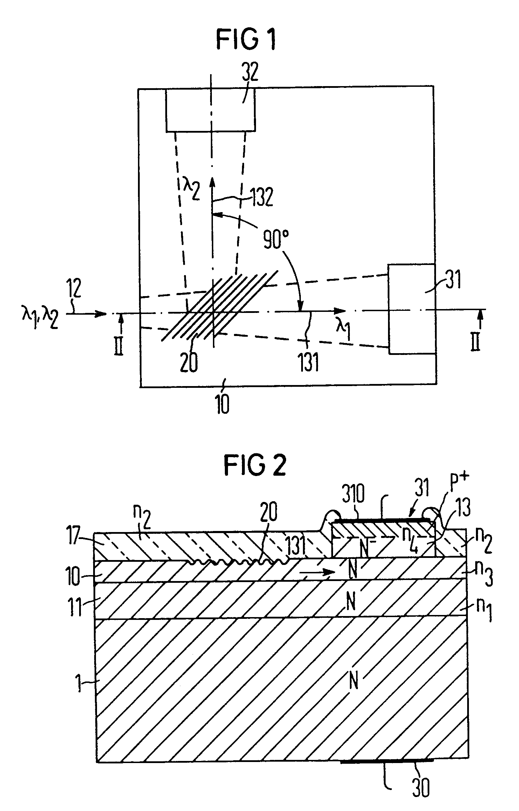

In der Fig.1 ist mit 10 ein Monomode-Schichtwellenleiter auf InP-Basis bezeichnet, in dem sich ein eindimensionaler Gauß'scher Strahl ausbreiten kann. In dem Schichtwellenleiter ist ein ebenes Gitter 20 ausgebildet, das beispielsweise durch Einschreiben mittels Elektronenstrahls hergestellt werden kann.

Das Gitter 20 ist so bemessen und angeordnet, daß eine zwei Wellenlängen λ₁ und λ₂ enthaltende Strahlung, die beispielsweise aus einer Monomode-Faser aus der bestimmten Richtung 12 in den Schichtwellenleiter 10 eingekoppelt wird und sich darin im wesentlichen in dieser bestimmten Richtung 12 ausbreitet, am Gitter 20 in zwei Strahlungsanteile aufspaltet, von denen der eine im wesentlichen nur noch die Wellenlänge λ₁, der andere dagegen im wesentlichen nur noch die andere Wellenlänge λ₂ enthält, und die sich in verschiedenen Richtungen 131 bzw. 132 im Schichtwellenleiter 10 ausbreiten. In der Fig.1 ist angenommen, daß die beiden Richtungen 131 und 132 einen Winkel von 90° zwischen sich einschließen und daß die Richtung 131 der bestimmten Richtung 12 entspricht.

Auf den Schichtwellenleiter 10 sind Fotodetektoren 31 und 32 aufgebracht, von denen der Detektor 31 den die Wellenlänge λ₁ enthaltenden Strahlungsanteil und der Detektor 32 den die Wellenlänge λ₂ enthaltenden Strahlungsanteil empfängt. Die beiden Fotodetektoren 31 und 32 bestehen aus Fotodioden, die durch Leckwellenkopplung an den Schichtwellenleiter 10 gekoppelt sind.

Typische Abmessungen des Moduls nach Fig.1 sind: Die in der Richtung 12 gemessene Länge beträgt wie seine senkrecht zur Richtung 12 gemessene Breite etwa 2 mm. Bei diesen Abmessungen liegen die Längs- und Querabmessungen der Detektoren etwa bei 100 µm.

Der innere Aufbau des Moduls nach Fig.1 geht aus der Schnittansicht nach Fig.2 hervor. Die Schicht 11 ist auf einem Substrat 1 aus InP aufgebracht, die epitaktisch aufgewachsen ist und nur dazu dient, die Oberfläche des Substrats 1 zu verbessern. Die Schicht 11 erübrigt sich, wenn das Substrat 1 bereits eine ausreichende Oberflächengüte aufweist.

Auf die Schicht 11 ist epitaktisch eine In₁₋ₓGaₓAs_{y}P₁₋ₓ aufgewachsen, die eine Dicke von höchstens 2 µm aufweist und die den Schichtwellenleiter bildet.

Das Substrat 1, die Schicht 11 und der Schichtwellenleiter 10 sind N-dotiert und leitend.

In die Oberfläche der Schicht 10 ist das Gitter 20 eingebracht, dessen Furchen in einer zur Zeichenebene senkrechten Ebene schräg zur Zeichenebene verlaufen.

Die Fotodiode 31 ist durch ein Stück einer In_{0,53}Ga_{0,47}As-Schicht 13 realisiert, die einen an die Schicht 10 angrenzenden Schichtbereich aufweist, der N⁻-dotiert oder eigenleitend ist, und an den auf der von der Schicht 10 abgekehrten Seite ein P⁺-dotierter Bereich angrenzt. Auf der Schicht 13 ist ein P-Kontakt 310 aufgebracht, dessen Gegenkontakt auf der gegenüberliegenden Seite des Substrats 1 als N-Kontakt 30 aufgebracht ist.

Die Schichtdicke des Schichtstückes 13 beträgt typischerweise 1 bis 3 µm. Die in der Richtung 131 gemessene Länge des Schichtstückes 13 beträgt typischerweise 10 bis 100 µm, während ihre senkrecht zur Richtung 131 gemessene Breite typischerweise bei 100 µm liegt.

Das Schichtstück 13 kann aus einer einzigen epitaktisch aufgewachsenen Schicht bestehen, in die der P⁺-dotierte Bereich durch Diffusion eingebracht ist, oder es kann aus einer epitaktisch aufgewachsenen N⁻-dotierten oder eigenleitenden Schicht und aus einer darauf epitaktisch aufgewachsenen P⁺-dotierten Schicht bestehen.

Sämtliche epitaktischen Schichten können durch Flüssigphasenepitaxie aufgewachsen werden.

Die Oberfläche des Moduls ist mit einer Deckschicht 17 abgedeckt, die aus Si₃N₄, Polyimid oder InP bestehen kann. Diese Materialien haben einen Brechungsindex n₂, der wie der Brechungsindex n₁ von InP kleiner ist wie der Brechungsindex N₃ der Schicht 10 aus InGaAsP. Dies ist notwendig, damit die Schicht 10 als Schichtwellenleiter wirken kann.

Das Schichtstück 13 aus InGaAs hat einen Brechungsindex n₄, der größer ist als der Brechungsindex n₃. Dies ist für die Realisierung einer Leckwellenkopplung notwendig.

Der Modul nach den Fig.1 und 2 kann mit nur einem einzigen Epitaxieschritt sehr einfach hergestellt werden. Dazu wird zunächst auf dem leitenden Substrat in einem einzigen Epitaxieschritt eine Schichtenfolge erzeugt, die den Schichten 11, 10 und 13 entspricht. Wie schon erwähnt, kann die dem Schichtstück 13 entsprechende Schicht aus einer einfachen Schicht oder aus einer Doppelschicht bestehen. Diese oberste einfache Schicht oder Doppelschicht wird bis auf das Schichtstück 13 beispielsweise durch chemisches Ätzen abgetragen. In die freigelegte Oberfläche der Schicht 10 wird beispielsweise mittels Elektronenstrahl das Gitter 20 eingeschrieben. Nach dem Aufbringen des P-Kontakts 310, beispielsweise durch Aufdampfen, wird die Deckschicht 17 aufgebracht. Der Kontakt 30 kann vor Beginn, während oder nach Beendigung des Verfahrens aufgebracht werden.

Wenn die dem Schichtstück 13 entsprechende Schicht eine Einfachschicht ist und der P⁺-dotierte Bereich durch Diffusion erzeugt wird, so kann diese Diffusion vor oder nach dem Abtragen dieser Schicht vorgenommen werden.

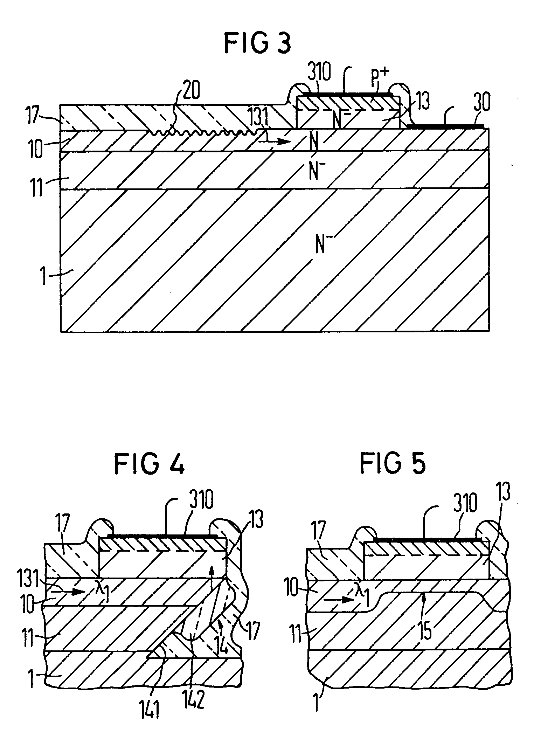

Die in der Fig.3 dargestellte modifizierte Ausführungsform des Moduls unterscheidet sich von dem Modul nach den Fig.1 und 2 lediglich dadurch, daß das Substrat 1 und die Schicht 11 semiisolierend sind und dadurch der N-Kontakt 30 nicht auf der den P-Kontakt 310 gegenüberliegenden Seite des Substrats 1, sondern auf der gleichen Seite wie der P-Kontakt 310 angeordnet ist.

Die Fig.4 zeigt ein bei dem Schichtstück 13 angeordnetes reflektierendes Element 14, das die am Schichtstück 13 vorbeigehende Strahlung in Richtung zum Schichtstück 13 reflektiert. Die Realisierung dieses reflektierenden Elementes kann so erfolgen, daß durch naßchemisches Ätzen oder durch Elektronenstrahlätzen eine Fläche 141 erzeugt wird, die sich quer über die Schicht 10 und schräg zur Richtung 131 erstreckt. Diese Fläche 141 kannn, wenn sie im richtigen Winkel angeordnet ist, Totalreflexion bewirken, und bildet dann bereits das reflektierende Element 14, das dann zweckmäßigerweise mit einer Schuchtschicht abgedeckt wird. Auf die Fläche 141 kann auch ein reflektierender Belag 142, beispielsweise eine dielektrische Vielfachschicht, aufgebracht werden. Zweckmäßig ist es, einen reflektierenden Belag 142 zu verwenden, der zusätzlich eine Filterwirkung derart aufweist, daß er für eine Strahlung mit störender Wellänge, die im Fall der Fig.4 die Wellenlänge 2 wäre, überflüssig ist. Diese störende Wellenlänge wird dann nicht in das Schichtstück 13 reflektiert. Ein solcher Belag kann ebenfalls durch eine Vielfachtschicht realisiert werden.

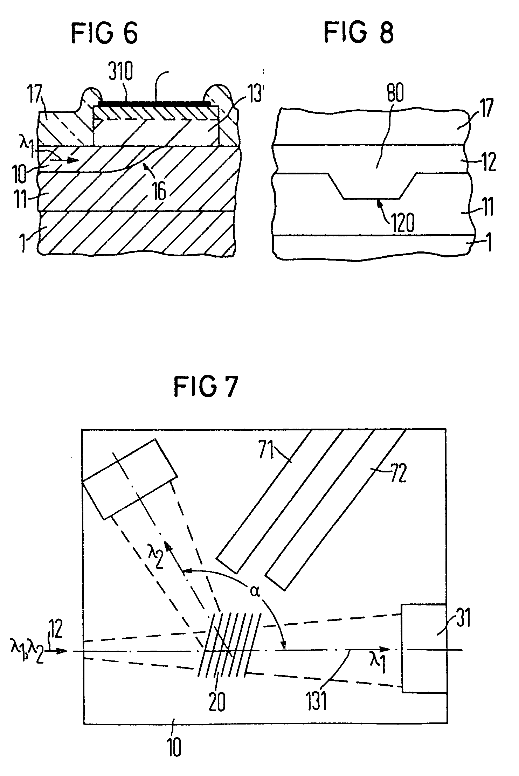

Die Fig .5 und 6 zeigen zwei Realisierungen von Verjüngungen des Schichtwellenleiter 10 im Bereich des Schichtstückes 13. Im Fall der Fig.5 erweitert sich der Schichtwellenleiter 10 nach der Verjüngung 15 wieder, während er im Fall der Fig.6 mit der Verjüngung 16 endet.

Die in der Fig.7 dargestellte Modifikation des Modulators nach Fig.1 unterscheidet sich von diesem im wesentlichen nur dadurch, daß die Furchen des Gitters 20 steiler als 45° zur Richtung 12 verlaufen, wodurch bewirkt wird, daß die Richtungen 131 und 132 nicht einen Winkel von 90°, sondern einen größeren Winkel α zwischen sich einschließen. Die Detektoren 31 und 32 sind dadurch weiter voneinander entfernt. Dadurch wird die Nebensprechdämpfung erhöht. Außerdem verläuft dazwischen den in den Richtungen 131 und 132 sich ausbreitenden Strahlungsanteilen und den Detektoren 31 und 32 eine Furche 71 und ein Erdungskontakt 72. Alle diese Maßnahmen tragen dazu bei, daß die Nebensprechdämpfung erhöht wird. Bei einem Kanalabstand von 10 bis 20 nm bei 1,55 µm kann eine Nebensprechdämpfung von mehr als 20 Dezibel, bezogen auf optische Leistung, erwartet werden. Vorausgesetzt ist dabei ein Gitter 20 mit einer Gitterlänge, das eine Spitzenreflexion für die reflektierte Wellenlänge λ₂ liefert, die größer als 0,99 ist.

Durch die in der Fig.8 in Stirnansicht gezeigte Verdickung 120 des Schichtwellenleiters 10 wird eine bessere Einkopplung der beispielsweise aus einer Monomode-Faser austretenden Strahlung in den Schichtwellenleiter 10 erreicht, weil diese Verdickung 120 dem Querschnitt der Faser, deren Achse durch den Punkt 80 und senkrecht zur Zeichenebene verläuft, besser angepaßt ist. Beispielsweise kann der Schichtwellenleiter im Bereich der Verdickung 120 doppelt so dick sein wie außerhalb. Die Kopplung zwischen der Monomode-Faser und dem Modul erfolgt zweckmäßigerweise über einen Fasertaper.

## Patentansprüche

1. Monolithisch integrierter Wellenlängen-Demultiplexmodul, wobei auf einem gemeinsamen Substrat (1)
- ein Schichtwellenleiter (10) zu Führung einer mehrere Wellenlängen (λ₁, λ₂) enthaltenden Strahlung,
- ein wellenlängenselektierendes Element (20) zur Aufspaltung der im Schichtwellenleiter (10) geführten und in einer bestimmten Richtung (12) sich ausbreitenden Strahlung in untereinander verschiedene Wellenlängen (λ₁, λ₂) enthaltende und in verschiedenen Richtungen (131, 132) im Schichtwellenleiter (10) sich ausbreitende Strahlungsanteile, und
- mehrere optisch an den Schichtwellenleiter (10) gekoppelte und jeweils einen der untereinander verschiedene Wellenlängen enthaltende und in verschiedenen Richtungen sich ausbreitende Strahlungsanteile empfangende Fotodetektoren (31, 32) ausgebildet sind,
dadurch **gekennzeichnet**,
daß das Substrat (1) aus InP und der Schichtwellenleiter (10) aus einer quaternären Schicht besteht, und daß der durch Leckwellenkopplung an den Schichtwellenleiter (10) optisch gekoppelte Fotodetektor (31, 32) eine oder mehrere, unterschiedliche Dotierungen aufweisende und unmittelbar auf den Schichtwellenleiter (10) aufgebrachte ternäre Schichten (13) aufweist.

2. Modul nach Anspruch 1, dadurch **gekennzeichnet**, daß die quaternäre Schicht aus InGaAsP besteht.

3. Modul nach Anspruch 1 oder 2, dadurch **gekennzeichnet**, daß eine ternäre Schicht aus InGaAs besteht.

4. Modul nach einem der vorhergehenden Ansprüche, dadurch **gekennzeichnet**, daß bei dem durch Leckwellenkopplung an den Schichtwellenleiter (10) optisch gekoppelten Fotodetektor (31, 32) ein quer zum Schichtwellenleiter (10) sich erstreckendes und schräg zur Ausbreitungsrichtung (131, 132) des von diesem Fotodetektor empfangenen Strahlungsanteiles angeordnetes reflektierendes Element (14) vorgesehen ist, das die am Fotodetektor vorbeigehende Strahlung in Richtung zum Fotodetektor reflektiert, und/oder daß der Schichtwellenleiter (10) im Bereich des Fotodetektors (131, 132) eine Verjüngung (15, 16) aufweist.

5. Modul nach Anspruch 4, dadurch **gekennzeichnet**, daß das reflektierende Element (14) ein Filter zur Ausfilterung einer störenden Wellenlänge aufweist.

6. Modul nach einem der vorhergehenden Ansprüche, dadurch **gekennzeichnet**, daß der Modul mit einer Deckschicht (17) abgedeckt ist.

7. Modul nach einem der vorhergehenden Ansprüche, insbesondere nach einem der Ansprüche 3 bis 6, dadurch **gekennzeichnet**, daß die Deckschicht (17) aus Si₃N₄, Polyimid oder InP besteht.

8. Verfahren zur Herstellung eines Moduls nach einem der vorhergehenden Ansprüche,
- wobei auf dem Substrat (1) in einem einzigen Epitaxieschritt eine Schichtenfolge erzeugt wird, bei der unmittelbar auf die für den Schichtwellenleiter (10) vorgesehene quaternäre Schicht zumindest eine ternäre Schicht folgt,
- wobei die ternäre Schicht außerhalb eines für einen Fotodetektor (31, 32) vorgesehenen Bereiches bis zur quaternären Schicht (10) abgetragen wird, und
- wobei dann auf dem freigelegten Bereich der quaternären Schicht (10) das wellenlängenselektierende Element (20) und auf der verbliebenen ternären Schicht (13) der Fotodetektor (31, 32) erzeugt wird.

## Claims

1. Monolithically integrated wavelength demultiplex module, there being formed on a common substrate (1)
- a film waveguide (10) for guiding radiation containing a plurality of wavelengths (λ₁, λ₂),
- a wavelength-selecting element (20) for splitting the radiation guided in the film waveguide (10) and propagating in a particular direction (12) into radiation components containing mutually different wavelengths (λ₁, λ₂) and propagating in different directions (131, 132) in the film waveguide (10), and
- a plurality of photodetectors (31, 32) which are optically coupled to the film waveguide (10) and receive radiation components containing in each case one of the mutually different wavelengths and propagating in different directions,
characterised in that the substrate (1) is composed of InP and the film waveguide (10) is composed of a quaternary layer, and in that the photodetector (31, 32) optically coupled to the film waveguide (10) by means of a leaky wave coupling has one or more ternary layers (13) which have different dopings and are applied directly onto the film waveguide (10).

2. Module according to Claim 1, characterised in that the quaternary layer is composed of InGaAsP.

3. Module according to Claim 1 or 2, characterised in that a ternary layer is composed of InGaAs.

4. Module according to one of the preceding claims, characterised in that there is provided in the photodetector (31, 32) optically coupled to the film waveguide (10) by means of a leaky wave coupling a reflecting element (14) which extends transversely relative to the film waveguide (10) and is arranged obliquely relative to the propagation direction (131, 132) of the radiation component received by said photodetector, which reflecting element reflects the radiation passing by the photodetector in the direction towards the photodetector, and/or in that the film waveguide (10) has a taper (15, 16) in the region of the photodetector (131, 132).

5. Module according to Claim 4, characterised in that the reflecting element (14) has a filter for filtering out an unwanted wavelength.

6. Module according to one of the preceding claims, characterised in that the module is covered by a cover layer (17).

7. Module according to one of the preceding claims, preferably according to one of Claims 3 to 6, characterised in that the cover layer (17) is composed of Si₃N₄, polyimide or InP.

8. Method for manufacturing a module according to one of the preceding claims,
- in which a layer sequence is formed on the substrate (1) in a single epitaxial step, in which sequence at least one ternary layer immediately follows the quaternary layer provided for the film waveguide (10),
- in which the ternary layer is removed down to the quaternary layer (10) outside a region provided for a photodetector (31, 32), and
- in which the wavelength-selecting element (20) is then formed on the exposed region of the quaternary layer (10) and the photodetector (31, 32) is formed on the remaining ternary layer (13).

## Revendications

1. Module intégré monolithique de démultiplexage des longueurs d'onde, dans lequel sur un substrat commun (1) sont formés
- un guide d'ondes en forme de couche (10) servant à guider un rayonnement comportant plusieurs longueurs d'onde (λ₁,λ₂),
- un élément (20) qui sélectionne les longueurs d'onde et qui sert à subdiviser le rayonnement qui est guidé dans le guide d'ondes en forme de couche (10) et se propage dans une direction déterminée (12), en des composantes de rayonnement qui comportent des longueurs d'onde différentes (λ₁,λ₂) et se propagent dans différentes directions (131,132) dans le guide d'ondes en forme de couche (10), et
- plusieurs photodétecteurs (31,32), qui sont accouplés optiquement au guide d'ondes en forme de couche (10) et qui comportent respectivement l'une des différentes longueurs d'onde et reçoivent des composantes de rayonnement se propageant dans différentes directions,
caractérisé par le fait
que le substrat (1) est constitué par du InP et le guide d'ondes en forme de couche (10) est constitué par une couche quaternaire, et que le photodétecteur (31,32) couplé optiquement au guide d'ondes en forme de couche (10) par l'intermédiaire d'un couplage d'ondes de fuite, comporte une ou plusieurs couches ternaires (13), qui possèdent des dopages différents et sont déposées directement sur le guide d'ondes en forme de couche (10).

2. Module suivant la revendication 1, caractérisé par le fait que la couche quaternaire est constituée par du InGaAsP.

3. Module suivant la revendication 1 ou 2, caractérisé par le fait qu'une couche ternaire est constituée par du InGaAs.

4. Module suivant l'une des revendications précédentes, caractérisé par le fait que dans le cas du photodétecteur (31,32) couplé optiquement au guide d'ondes en forme de couche (10) sous l'effet du couplage d'ondes de fuite, il est prévu un élément réfléchissant (14), qui s'étend transversalement par rapport au guide d'ondes en forme de couche (10), qui est disposé obliquement par rapport à la direction de propagation (131,132) de la composante de rayonnement reçue par ce photodétecteur et qui réfléchit le rayonnement passant dans le photodétecteur en direction du photodétecteur et/ou que le guide d'ondes en forme de couche (10) possède un rétrécissement (15,16) dans la zone du photodétecteur (131,132).

5. Module suivant la revendication 4, caractérisé par le fait que l'élément réfléchissant (14) possède un filtre servant à éliminer par filtrage une longueur d'onde gênante.

6. Module suivant l'une des revendications précédentes, caractérisé par le fait que le module est recouvert par une couche de revêtement (17).

7. Module suivant l'une des revendications précédentes, notamment suivant l'une des revendications 3 à 6, caractérisé par le fait que la couche de revêtement (17) est constituée par du Si₃N₄, du polyimide ou du InP.

8. Procédé pour fabriquer un module suivant l'une des revendications précédentes, selon lequel
- en une seule étape épitaxiale, on dépose sur le substrat (1) une succession de couches, dans laquelle au moins une couche ternaire succède directement à la couche quaternaire prévue pour le guide d'ondes en forme de couche (10),
- la couche ternaire est éliminée, à l'extérieur d'une zone prévue pour un photodétecteur (31,32), jusqu'à la couche quaternaire (10), et
- on forme ensuite l'élément (20) de sélection des longueurs d'onde sur la zone mise à nu de la couche quaternaire (10) et on forme le photodétecteur (31,32) sur la couche quaternaire subsistante (13).
